# EUROPÄISCHE PATENTANMELDUNG

(11) **EP 4 224 690 A1**
(43) Veröffentlichungstag der Anmeldung: **09.08.2023**
(21) Anmeldenummer: 23171261.3
(22) Anmeldetag: 18.06.2021
(51) Int. Cl.: H02M 7/00, H01L 25/065, H01L 25/07, H01L 25/11, H01G 9/26, H02G 5/00, H01G 4/40

(54) **ELEKTRISCHE SCHALTUNGSANORDNUNG, SCHIENENFAHRZEUG UND VERFAHREN ZUR HERSTELLUNG EINER ELEKTRISCHEN SCHALTUNGSANORDNUNG**

(30) Priorität: 22.06.2020 DE 102020207696
(62) Teilanmeldung aus: 21180255.8
(71) Anmelder: Bombardier Transportation GmbH, 10785 Berlin (DE)
(72) Erfinder: Reinhard, Dominik, 8037 Zürich (CH); Manser, Roland, 5417 Untersiggenthal (CH); Allenbach, Sebastian, 8050 Zürich (CH)
(74) Vertreter: Ramrath, Lukas

(57) **Zusammenfassung**

Die Erfindung betrifft eine elektrische Schaltungsanordnung umfassend mindestens ein Leistungsschaltelement (8), einen Hochvoltleiter (2), einen Niedervoltleiter (3) und mindestens einen Kommutierungszweig (4), wobei der Kommutierungszweig (4) einen elektrisch mit dem Hochvoltleiter (2) verbundenen Hochvolt-Anschlussabschnitt (6), einen elektrisch mit dem Niedervoltleiter (3) verbundenen Niedervolt-Anschlussabschnitt (7) und mindestens ein kapazitives Element (5) umfasst, welches elektrisch zwischen dem Hochvolt-Anschlussabschnitt (6) und dem Niedervolt-Anschlussabschnitt (7) angeordnet ist, wobei der Hochvolt-Anschlussabschnitt (7) des Kommutierungszweigs (4) zumindest teilweise durch ein Material ausgebildet ist, dessen elektrische Leitfähigkeit geringer ist als die elektrische Leitfähigkeit des Materials des Hochvoltleiters (2) sowie ein Schienenfahrzeug und Verfahren zur Herstellung einer elektrischen Schaltungsanordnung.

## Beschreibung

Die Erfindung betrifft eine elektrische Schaltungsanordnung, insbesondere zur Verwendung in einem Schienenfahrzeug, ein Schienenfahrzeug sowie ein Verfahren zur Herstellung einer solchen elektrischen Schaltungsanordnung.

Es ist bekannt, eine Wechselspannung durch sogenannte Wechselrichter zu erzeugen, die Leistungsschaltelemente, insbesondere IGBT, umfassen. In der Regel ist hierzu ein sogenannter Zwischenkreis mit einem Zwischenkreiskondensator vorhanden, der eine Gleichspannung für den Wechselrichter bereitstellt, wobei aus dieser Gleichspannung dann durch Schalten der Schaltelemente die erläuterte Wechselspannung erzeugt wird. Diese kann beispielsweise zum Betrieb einer elektrischen Maschine dienen. Die elektrische Maschine kann beispielsweise eine Traktionsmaschine in einem Schienenfahrzeug sein.

Weiter bekannt sind sogenannte Kommutierungskreise für die Leistungsschaltelemente, durch die ein Strom insbesondere nach einem Ausschalten (Sperrend-Schalten) eines Leistungsschaltelements fließt. Solch ein Kommutierungskreis ist in der Regel parallel zu einem Leistungsschaltelement angeordnet und umfasst zumindest ein kapazitives Element. Sind mehrere Leistungsschaltelemente im Wechselrichter vorhanden, so kann zu jedem dieser Leistungsschaltelemente ein solcher Kommutierungskreis mit einem kapazitiven Element parallelgeschaltet sein, wobei die kapazitiven Elemente dann über den Zwischenkreis miteinander verbunden sind.

Weiter sind Induktivitäten im Zwischenkreis vorhanden, die beispielsweise durch die verwendeten Leiter und deren Relativanordnung zueinander im Zwischenkreis entstehen. In Verbindung mit den vorhergehend erläuterten kapazitiven Elementen von Kommutierungskreisen können somit Schwingkreise entstehen, die wiederum hohe Ausgleichsströme zwischen den kapazitiven Elementen der Kommutierungskreise bedingen. Diese hohen Ausgleichströme können wiederum die thermische Belastung der kapazitiven Elemente in unerwünschter Weise erhöhen. Ist ein Dämpfungsgrad der Schwingkreise gering, so klingen die Schwingungen nur langsam ab, was die genannte thermische Belastung verlängert und/oder erhöht. Die Verwendung von kapazitiven Elementen mit einer hohen Kapazität und hoher Stromtragfähigkeit führt in der Regel zu einem hohen Bauraumbedarf und Gewicht, was ebenfalls unerwünscht ist.

Es stellt sich daher das technische Problem, eine elektrische Schaltungsanordnung, ein Schienenfahrzeug und ein Verfahren zur Herstellung einer Schaltungsanordnung zu schaffen, welche die genannten Nachteile vermeiden und insbesondere einen Stromfluss durch ein kapazitives Element eines Kommutierungszweigs reduzieren, wodurch wiederum eine thermische Belastung dieses kapazitiven Elements reduziert wird, sich die Lebensdauer der Schaltungsanordnung erhöht und sich Bauraumanforderungen reduzieren.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird eine elektrische Schaltungsanordnung. Diese kann insbesondere Teil eines Traktionsnetzes in einem Fahrzeug, insbesondere einem Schienenfahrzeug, sein. Insbesondere kann die Schaltungsanordnung einen Teil eines Zwischenkreises in einem elektrischen Netz bilden, wobei an diesen Zwischenkreis mindestens ein Leistungsschaltelement zur Erzeugung einer Wechselspannung angeschlossen ist.

Die elektrische Schaltungsanordnung umfasst mindestens ein Leistungsschaltelement, welches vorzugsweise als IGBT ausgebildet ist. Selbstverständlich können jedoch auch andere Leistungsschaltelemente eingesetzt werden, beispielsweise MOSFETs. Weiter umfasst die Schaltungsanordnung einen Hochvoltleiter und einen Niedervoltleiter. Im Kontext dieser Offenbarung bezeichnet ein Hochvoltleiter einen elektrischen Leiter, der in dem bestimmungsgemäßen Betrieb der elektrischen Schaltungsanordnung ein höheres Potential aufweist als der Niedervoltleiter, der ebenfalls ein elektrischer Leiter ist. Der Niedervoltleiter kann z.B. ein Massepotential des Schienenfahrzeugs aufweisen. Der Hochvoltleiter und der Niedervoltleiter können insbesondere als Stromschiene (Busbar) ausgebildet sein, wobei der Hochvoltleiter dann als Plus-Stromschiene und der Niedervoltleiter dann als Minus-Stromschiene bezeichnet werden kann. Der Hochvoltleiter und der Niedervoltleiter können vorzugsweise aus Aluminium ausgebildet sein. Es ist allerdings auch möglich, dass ein solcher Leiter aus Kupfer oder einem anderen leitfähigen Material ausgebildet ist.

Weiter umfasst die Schaltungsanordnung einen Kommutierungszweig, wobei der Kommutierungszweig einen elektrisch mit dem Hochvoltleiter verbundenen Hochvolt-Anschlussabschnitt, einen elektrisch mit dem Niedervoltleiter verbundenen Niedervolt-Anschlussabschnitt und mindestens ein kapazitives Element umfasst. Hierbei können sowohl der Hochvolt-Anschlussabschnitt als auch der Niedervolt-Anschlussabschnitt auch mechanisch mit dem entsprechenden Hochvolt- bzw. Niedervoltleiter verbunden sein, beispielweise durch eine Schraubverbindung.

Insbesondere kann der Hochvolt-Anschlussabschnitt eine Hochvolt-Klemme des kapazitiven Elements mit einer Hochvolt-Klemme des Leistungsschaltelements verbinden. Weiter kann der Niedervolt-Anschlussabschnitt eine Niedervolt-Klemme des kapazitiven Elements mit einer Niedervolt-Klemme des Leistungsschaltelements verbinden.

Das kapazitive Element kann insbesondere als Kondensator ausgebildet sein. Die Kapazität eines solchen Kondensators kann hierbei anwendungsabhängig gewählt werden. Typischerweise kann die Kapazität in einem Bereich von 1-20 µF liegen. Ein solcher Kondensator kann auch als Snubber-Kondensator bezeichnet werden.

Das kapazitive Element ist elektrisch zwischen dem Hochvolt-Anschlussabschnitt und dem Niedervolt-Anschlussabschnitt angeordnet.

Weiter sind ein Hochvoltanschluss des Leistungsschaltelements elektrisch mit dem Hochvoltleiter und ein Niedervoltanschluss des Leistungsschaltelements mit dem Niedervoltleiter elektrisch verbunden. Somit ist der Kommutierungszweig in der vorgeschlagenen Schaltungsanordnung elektrisch parallel zum Leistungsschaltelement angeordnet.

Erfindungsgemäß ist der Hochvolt-Anschlussabschnitt des Kommutierungszweigs zumindest teilweise oder aber vollständig durch ein Material ausgebildet, dessen elektrische Leitfähigkeit geringer ist als die elektrische Leitfähigkeit des Materials des Hochvoltleiters. Alternativ oder kumulativ ist der Niedervolt-Anschlussabschnitt des Kommutierungszweigs zumindest teilweise oder aber vollständig durch ein Material ausgebildet, dessen elektrische Leitfähigkeit geringer ist als die elektrische Leitfähigkeit des Materials des Niedervoltleiters.

Mit anderen Worten ist ein spezifischer Widerstand des Materials des Hochvolt-Anschlussabschnitts größer als der spezifische Widerstand des Materials des Hochvoltleiters. Alternativ oder kumulativ ist ein spezifischer Widerstand des Materials des Niedervolt-Anschlussabschnitts größer als der spezifische Widerstand des Materials des Niedervoltleiters.

Hierdurch kann in vorteilhafter Weise mit sehr geringem Bauraumbedarf ein gewünschter (hoher) Widerstand des Kommutierungszweigs erreicht werden, wodurch die vorhergehend erläuterten Stromschwingungen aufgrund des durch Kommutierungszweig und Zwischenkreis gebildeten Schwingkreises zeitlich schnell in ihrer Amplitude abnehmen und auch die maximale Amplitude solcher Schwingungen reduziert wird. Hierdurch wiederum ergibt sich in vorteilhafter Weise, dass eine thermische Belastung des kapazitiven Elements im Kommutierungszweig reduziert wird, wodurch wiederum wenig Bauraum und Herstellungskosten benötigende kapazitive Elemente verwendet werden können.

Weiter ergibt sich, dass eine Trennung zwischen Laststrom, also dem über den Hochvoltleiter, das Leistungsschaltelement und den Niedervolleiter fließenden Strom, und Snubberkondensatorstrom erfolgen kann.

In einer weiteren Ausführungsform ist der Hochvolt-Anschlussabschnitt und/oder der Niedervolt-Anschlussabschnitt zumindest teilweise plattenförmig ausgebildet. Dies kann bedeuten, dass der Anschlussabschnitt als Leiterplatte ausgebildet ist oder eine Leiterplatte umfasst. Die Leiterplatte bzw. der plattenförmig ausgebildete Abschnitt kann hierbei eine vorbestimmte Dicke/Stärke aufweisen, insbesondere im Bereich von 0,2 mm bis 2,0 mm, vorzugsweise im Bereich von 0,5 mm bis 1,5 mm.

Hierdurch ergibt sich in vorteilhafter Weise ein kostengünstig und einfach herstellbarer Anschlussabschnitt mit den gewünschten Leitfähigkeitseigenschaften, der wenig Bauraum benötigt.

In einer weiteren Ausführungsform ist zumindest ein Teilabschnitt des Hochvolt-Anschlussabschnitts geschlitzt ausgebildet und/oder zumindest ein Teilabschnitt des Niedervolt-Anschlussabschnitts geschlitzt ausgebildet. Insbesondere kann der vorhergehend erläuterte plattenförmige Abschnitt des Anschlussabschnitts zumindest teilweise geschlitzt ausgebildet sein. Ein geschlitzter Teilabschnitt kann hierbei Leiterstege umfassen oder ausbilden, wobei zwischen Leiterstegen ein elektrisch nicht oder weniger leitfähiger Abschnitt angeordnet ist. Beispielsweise kann zwischen zwei solchen Stegen aus dem Material des Anschlussabschnitts Luft angeordnet sein. In diesem Fall kann der geschlitzte Teilabschnitt also auch Durchgangsöffnungen in Form von Schlitzen aufweisen.

Hierdurch ergibt sich in vorteilhafter Weise eine mechanisch einfache Herstellung des Anschlussabschnitts mit der gewünschten elektrischen Leitfähigkeit, da durch die geschlitzte Ausbildung elektrische Leitfähigkeit durch einfache mechanische Herstellungsmaßnahmen reduziert werden kann.

In einer weiteren Ausführungsform ist zumindest ein Randbereich des Hochvolt-Anschlussabschnitts und/oder zumindest ein Randbereich des Niedervolt-Anschlussabschnitts vollflächig ausgebildet. Dies kann bedeuten, dass der Randbereich nicht geschlitzt und nicht gelocht ausgebildet ist und insbesondere auch keine Verjüngungen der Dicke aufweist. Weiter kann dies bedeuten, dass der Randbereich als Vollkörper aus dem Material des Anschlussabschnitts ausgebildet ist. Vorzugsweise umfasst der Hochvolt- bzw. Niedervolt-Anschlussabschnitt, insbesondere ein plattenförmig ausgebildeter Anschlussabschnitt, zwei derart vollflächig ausgebildete Randbereiche, wobei zwischen diesen Randbereichen ein geschlitzter Teilbereich angeordnet ist. Ein erster Randbereich kann hierbei elektrisch und mechanisch mit dem Hochvoltleiter verbunden sein, wobei der zweite Randbereich elektrisch und mechanisch mit dem kapazitiven Element verbunden ist.

Hierdurch ergibt sich in vorteilhafter Weise, dass aufgrund dieser Ausbildung der Randbereiche sowie ihrer höheren Leitfähigkeit im Vergleich zu einem nicht vollflächigen weiteren (Zwischen)-Bereich des Anschlussabschnitts eine geringe Wärmeentwicklung in diesen Randbereichen erfolgt, wodurch in vorteilhafter Weise eine thermische Belastung des kapazitiven Elements und/oder des Leistungsschaltelements, der/die unmittelbar in Nähe des vorhergehend erläuterten ersten Randbereichs angeordnet sein kann/können, reduziert werden kann und insbesondere gewünschte Betriebstemperaturen nicht überschritten werden. Hierdurch erhöht sich in vorteilhafter Weise eine Betriebssicherheit der Schaltungsanordnung und eine Lebensdauer.

In einer bevorzugten Ausführungsform ist der Hochvolt-Anschlussabschnitt des Kommutierungszweigs und/oder der Niedervolt-Anschlussabschnitt zumindest teilweise durch Edelstahl ausgebildet. So kann eine Hochvolt-Anschlussplatte oder eine Niedervolt-Anschlussplatte eine Edelstahlplatte sein. Hierdurch ergibt sich in vorteilhafter Weise eine kostengünstige Ausbildung des Anschlussabschnitts mit in der Regel gut verfügbaren Materialien.

In einer weiteren Ausführungsform umfassen der Hochvoltleiter und der Niedervoltleiter jeweils mindestens einen plattenförmig ausgebildeten Abschnitt, wobei die plattenförmig ausgebildeten Abschnitte parallel zueinander angeordnet sind.

Weiter umfasst der Hochvolt-Anschlussabschnitt und/oder der Niedervolt-Anschlussabschnitt des Kommutierungszweigs - wie vorhergehend erläutert - zumindest einen plattenförmig ausgebildeten Teilabschnitt, wobei dieser parallel zu den plattenförmigen Abschnitten des Hochvoltleiters und des Niedervoltleiters sowie auf einer dem Hochvoltleiter abgewandten Seite des Niedervoltleiters angeordnet ist. Vorzugsweise sind die plattenförmigen Abschnitte eben, also ungekrümmt, ausgebildet. Es ist jedoch auch möglich, dass die genannten Abschnitte gekrümmt ausgebildet sind. Zwischen den plattenförmigen Abschnitten kann ein Isolationsmaterial zur elektrischen Isolierung angeordnet sein. Dieses kann beispielsweise in Form einer Folie, einer Beschichtung oder eines Füllmaterials, beispielsweise Kunststoff, ausgebildet sein.

Durch die Anordnung ergibt sich in vorteilhafter Weise eine geometrische Relativanordnung, durch die eine gewünschte, niedrige Induktivität der Schaltungsanordnung erreicht werden kann, wodurch wiederum die vorhergehend erläuterten Stromschwingungen in gewünschter Weise reduziert werden können. Ebenfalls ergibt sich in technisch vorteilhafter Weise eine hohe bauliche Integration und somit ein geringer Bauraumbedarf der gesamten Anordnung.

In einer weiteren Ausführungsform ist eine Dicke des plattenförmig ausgebildeten Teilabschnitts des Anschlussabschnitts geringer als eine Dicke des plattenförmigen Abschnitts des Hochvoltleiters. Alternativ oder kumulativ kann die Dicke des plattenförmig ausgebildeten Teilabschnitts geringer als eine Dicke des plattenförmigen Abschnitts des Niedervoltleiters sein. Exemplarische Bereiche für die Dicke/Stärke des Anschlussabschnitts wurden vorhergehend erläutert. Eine Dicke eines plattenförmig ausgebildeten Abschnitts des Hochvoltleiters bzw. des Niedervoltleiters kann im Bereich von 3 mm bis 7 mm, vorzugsweise bei 5 mm, liegen.

Hierdurch ergibt sich in vorteilhafter Weise eine einfache Einstellung der gewünschten geringeren Leitfähigkeit aufgrund der mechanischen Ausbildung, da die geringere Dicke des plattenförmig ausgebildeten Teilabschnitts einen höheren elektrischen Widerstand als die plattenförmigen Abschnitte des Hochvoltleiters bzw. des Niedervoltleiters bedingt, die sich jedoch hauptsächlich auch aufgrund des Materials des Hochvoltleiters und/oder des Niedervoltleiters ergibt.

In einer weiteren Ausführungsform ist ein Abstand zwischen dem plattenförmig ausgebildeten Teilabschnitt des Anschlussabschnitts und dem plattenförmigen Abschnitt des Niedervoltleiters gleich dem Abstand zwischen dem plattenförmig ausgebildeten Teilabschnitt des Anschlussabschnitts und dem plattenförmigen Abschnitt des Hochvoltleiters. Dieser Abstand kann beispielsweise in einem Bereich von 2 mm bis 6 mm, vorzugsweise bei 4 mm, liegen. Selbstverständlich kann ein solcher Abstand auch anwendungsabhängig gewählt werden, insbesondere derart, dass gewünschte Isolationseigenschaften zwischen den Abschnitten gewährleistet sind, jedoch ein möglichst geringer Abstand vorhanden ist. Hierdurch ergibt sich in vorteilhafter Weise eine sehr geringe Induktivität der vorgeschlagenen Schaltungsanordnung mit den vorhergehend bereits erläuterten technischen Vorteilen.

In einer weiteren Ausführungsform ist ein Hochvoltanschluss des Leistungsschaltelements über den Hochvolt-Anschlussabschnitt mit dem Hochvoltleiter verbunden. Alternativ oder kumulativ ist ein Niedervoltanschluss des Leistungsschaltelements über den Niedervolt-Anschlussabschnitt mit dem Niedervoltleiter verbunden In diesem Fall kann also ein Laststrom, der im Betrieb des Leistungsschaltelements über dieses Element fließt, von dem Hochvoltleiter über den Hochvolt-Anschlussabschnitt, insbesondere den vorhergehend erläuterten Randbereich, zum Hochvoltanschluss des Leistungsschaltelements fließen. Auch kann der Laststrom, der im Betrieb des Leistungsschaltelements über dieses Element fließt, von dem Niedervoltanschluss des Leistungsschaltelements über den Niedervolt-Anschlussabschnitt, insbesondere den vorhergehend erläuterten Randbereich, zum Niedervoltleiter fließen. Hierdurch ergibt sich in vorteilhafter Weise eine hohe bauliche Integration und somit ein geringer Bauraumbedarf der vorgeschlagenen Schaltungsanordnung.

In einer weiteren Ausführungsform weist der Hochvolt-Anschlussabschnitt eine Durchgangsöffnung auf oder bildet diese aus, wobei diese Durchgangsöffnung zur Anordnung des Niedervolt-Anschlussabschnitts ausgebildet ist. Insbesondere kann sich also ein Verbindungselement/-abschnitt/-mittel von einem Niedervoltanschluss des kapazitiven Elements zum Niedervoltleiter durch die Durchgangsöffnung erstrecken. Alternativ oder kumulativ weist der Niedervolt-Anschlussabschnitt eine Durchgangsöffnung auf oder bildet diese aus, wobei diese Durchgangsöffnung zur Anordnung des Hochvolt-Anschlussabschnitts ausgebildet ist. Insbesondere kann sich also ein Verbindungselement/-abschnitt/-mittel von einem Hochvoltanschluss des kapazitiven Elements zum Hochvoltleiter durch die Durchgangsöffnung erstrecken.

Die Durchgangsöffnung kann hierbei in dem vorhergehend erläuterten geschlitzten Teilbereich des Anschlussabschnitts ausgebildet sein.

Hierdurch ergibt sich in vorteilhafter Weise eine weitere Verbesserung der baulichen Integration und eine weitere Einsparung von Bauraumbedarf.

Es ist selbstverständlich aber auch möglich, dass sich ein Verbindungselement/- abschnitt/-mittel von einem Anschluss des kapazitiven Elements zum Hoch- bzw. Niedervoltleiter nicht durch eine Durchgangsöffnung im Anschlussabschnitt erstreckt. Z.B. kann das/der Verbindungselement/-abschnitt/-mittel um den Anschlussabschnitt herumgeführt sein oder neben dem Anschlussabschnitt angeordnet sein.

Weiter vorgeschlagen wird ein Schienenfahrzeug mit einer elektrischen Schaltungsanordnung gemäß einer der in dieser Offenbarung beschriebenen Ausführungsform. Das Schienenfahrzeug kann hierbei insbesondere ein Traktionsnetz aufweisen, welches einen Zwischenkreis mit einem Zwischenkreiskondensator umfasst, wobei die erläuterte Schaltungsanordnung mit dem Zwischenkreis, insbesondere dem Zwischenkreiskondensator, verbunden ist. So kann beispielsweise der Hochvoltleiter des Zwischenkreises mit einem Hochvoltanschluss des Zwischenkreiskondensators und der Niedervoltleiter des Zwischenkreises mit einem Niedervoltanschluss des Zwischenkreiskondensators verbunden sein.

Es ist vorstellbar, dass die Schaltungsanordnung mehr als ein Leistungsschaltelement und mehr als einen Kommutierungszweig umfasst, wobei ein Hochvoltanschluss jedes Leistungsschaltelements mit dem Hochvoltleiter und ein Niedervoltanschluss des entsprechenden Leistungsschaltelements mit dem Niedervoltleiter verbunden ist. Weiter kann zu jedem Leistungsschaltelement ein Kommutierungszweig gemäß einer in dieser Offenbarung beschriebenen Ausführungsformen parallelgeschaltet sein.

Das Leistungsschaltelement kann im Schienenfahrzeug Teil eines Wechselrichters sein, der zur Bereitstellung einer Wechselspannung für den Betrieb einer elektrischen Maschine, insbesondere einer Traktionsmaschine, dient.

Weiter vorgeschlagen wird ein Verfahren zur Herstellung einer elektrischen Schaltungsanordnung gemäß einer der in dieser Offenbarung beschriebenen Ausführungsformen. Hierbei wird mindestens ein Leistungsschaltelement, mindestens ein Hochvoltleiter, mindestens ein Niedervoltleiter und mindestens ein Kommutierungszweig mit einem Hochvolt-Anschlussabschnitt, einem Niedervolt-Anschlussabschnitt und mindestens einem kapazitiven Element, welches elektrisch zwischen dem Hochvolt-Anschlussabschnitt und dem Niedervolt-Anschlussabschnitt angeordnet ist, bereitgestellt. Weiter wird der Hochvolt-Anschlussabschnitt elektrisch mit dem Hochvoltleiter und der Niedervolt-Anschlussabschnitt elektrisch mit dem Niedervoltleiter verbunden.

Erfindungsgemäß wird der Hochvolt-Anschlussabschnitt des Kommutierungszweigs zumindest teilweise durch ein Material ausgebildet, dessen elektrische Leitfähigkeit geringer als die elektrische Leitfähigkeit des Materials des Hochvoltleiters ist. Alternativ oder kumulativ wird der Niedervolt-Anschlussabschnitt des Kommutierungszweigs zumindest teilweise durch ein Material ausgebildet, dessen elektrische Leitfähigkeit geringer als die elektrische Leitfähigkeit des Materials des Niedervoltleiters ist.

Hierdurch ergibt sich in vorteilhafter Weise eine einfache Herstellung der elektrischen Schaltungsanordnung mit den entsprechend vorhergehend beschriebenen Vorteilen.

Die Erfindung wird anhand von Ausführungsbeispielen näher erläutert. Die Figuren zeigen:
- Fig. 1: eine schematische Seitenansicht einer erfindungsgemäßen Schaltungsanordnung,
- Fig. 2: eine weitere schematische Seitenansicht einer erfindungsgemäßen Schaltungsanordnung,
- Fig. 3: eine schematische Draufsicht auf einen Hochvolt-Anschlussabschnitt gemäß einer ersten Ausführungsform,
- Fig. 4: eine perspektivische Ansicht einer vorgeschlagenen Schaltungsanordnung,
- Fig. 5: eine perspektivische Ansicht einer erfindungsgemäßen Schaltungsanordnung in einer weiteren Ausführungsform und
- Fig. 6: eine schematische Draufsicht auf einen Hochvolt-Anschlussabschnitt in einer weiteren Ausführungsform.

Nachfolgend bezeichnen gleiche Bezugszeichen Elemente mit gleichen oder ähnlichen technischen Merkmalen.

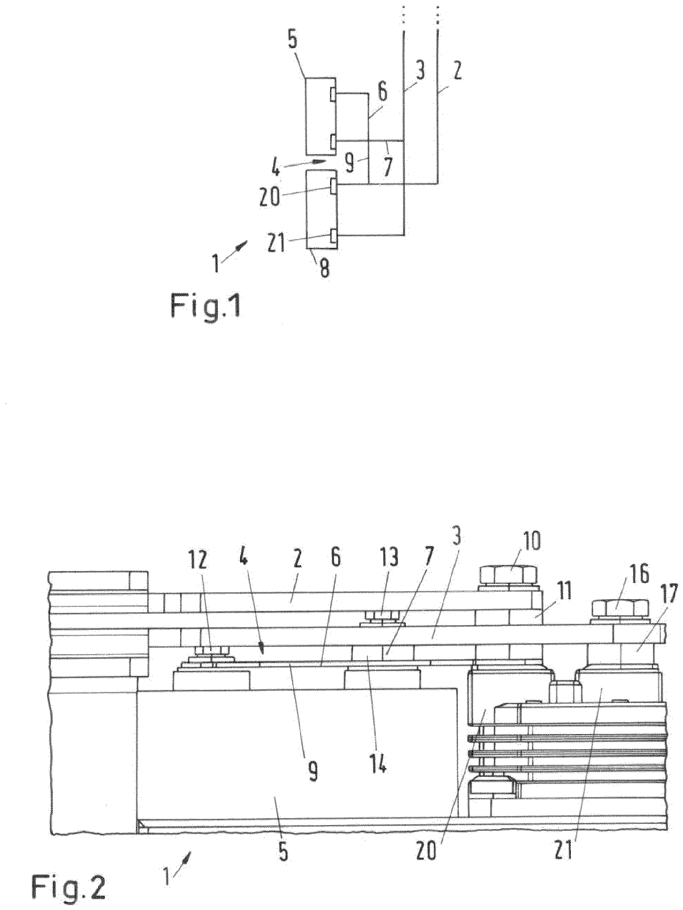

In Fig. 1 ist eine schematische Seitenansicht einer vorgeschlagenen elektrischen Schaltungsanordnung 1 dargestellt. Die Schaltungsanordnung 1 umfasst einen als Stromschiene ausgebildeten Hochvoltleiter 2 sowie einen ebenfalls als Stromschiene ausgebildeten Niedervoltleiter 3. Ebenfalls umfasst die Schaltungsanordnung 1 einen Kommutierungszweig 4, wobei dieser einen Kommutierungskondensator 5, einen Hochvolt-Anschlussabschnitt 6 und einen Niedervolt-Anschlussabschnitt 7 umfasst. Es ist ersichtlich, dass der Kommutierungskondensator 5 elektrisch zwischen dem Hochvolt-Anschlussabschnitt 6 und dem Niedervolt-Anschlussabschnitt 7 angeordnet ist.

Weiter erkennbar ist, dass der Hochvolt-Anschlussabschnitt 6 elektrisch mit dem Hochvoltleiter 2 und der Niedervolt-Anschlussabschnitt 7 elektrisch mit dem Niedervoltleiter 3 verbunden ist.

Weiter dargestellt ist ein als IGBT ausgebildetes Leistungsschaltelement 8, dessen Hochvoltanschluss 20 mit dem Hochvoltleiter 2 und dessen Niedervoltanschluss 21 mit dem Niedervoltleiter 3 elektrisch verbunden ist.

Weiter ersichtlich ist, dass der Hochvolt-Anschlussabschnitt 6 einen plattenförmigen Teilabschnitt 9 umfasst. Das Material des Hochvolt-Anschlussabschnitts 6, insbesondere des plattenförmigen Teilabschnitts 9, kann hierbei Edelstahl sein, wobei ein Material des Hochvoltleiters 2 und des Niedervoltleiters 3 Aluminium oder Kupfer sein kann.

Ebenfalls dargestellt ist, dass der Hochvoltleiter 2 und der Niedervoltleiter 3 jeweils plattenförmig ausgebildete Abschnitte umfassen, die parallel zueinander und parallel zu dem plattenförmigen Teilabschnitt 9 des Hochvolt-Anschlussabschnitts 6 angeordnet sind. Weiter ist dargestellt, dass der plattenförmige Teilabschnitt 9 des Hochvolt-Anschlussabschnitts 6 des Kommutierungszweigs 4 auf einer dem Hochvoltleiter 2 abgewandten Seite des Niedervoltleiters 3 angeordnet ist. Somit ist der Hochvolt-Anschlussabschnitt 6 zwischen Niedervoltleiter 3 und dem Kommutierungskondensator 5 angeordnet.

Fig. 2 zeigt eine weitere schematische Seitenansicht einer Schaltungsanordnung 1. Erkennbar ist wiederum der Hochvoltleiter 2, der Niedervoltleiter 3 sowie der Kommutierungszweig 4, welcher einen plattenförmig ausgebildeten Hochvolt-Anschlussabschnitt 6, den Kommutierungskondensator 5 sowie einen Niedervolt-Anschlussabschnitt 7 umfasst.

Es ist dargestellt, dass eine Dicke des plattenförmig ausgebildeten Teilabschnitts 9 des Hochvolt-Anschlussabschnitts 6 geringer ist als eine Dicke des plattenförmig ausgebildeten Abschnitts des Hochvoltleiters 2, zu welchem der plattenförmig ausgebildete Teilabschnitt 9 des Hochvolt-Anschlussabschnitts 6 parallel orientiert ist. Ebenfalls ist dessen Dicke geringer als die Dicke des plattenförmig ausgebildeten Abschnitts des Niedervoltleiters 3.

Weiter erkennbar ist, dass der Hochvolt-Anschlussabschnitt 6 über eine Schraube 10 mit dem Hochvoltleiter 2 mechanisch verbunden ist, wobei ferner eine Abstandshalterhülse 11 zwischen dem Hochvoltleiter 2 und dem Hochvolt-Anschlussabschnitt 6 angeordnet ist, die einen gewünschten Abstand zwischen dem Leistungsschaltelement 8 und dem Hochvoltleiter 2 gewährleistet. Diese Abstandshalterhülse 11 erstreckt sich hierbei durch eine Durchgangsöffnung im plattenförmigen Abschnitt des Niedervoltleiters 3 und dient zur elektrischen Verbindung zwischen Hochvoltleiter 2 und Hochvolt-Anschlussabschnitt 6. Daher ist diese Abstandshalterhülse 11 aus einem elektrisch leitfähigen Material ausgebildet, vorzugsweise mit der gleichen Leitfähigkeit wie das Material des Hochvoltleiters 2.

Weiter dargestellt ist, dass der Hochvoltanschluss 20 des Leistungsschaltelements 8 über den Hochvolt-Anschlussabschnitt 6 des Kommutierungszweigs 4 mit dem Hochvoltleiter 2 verbunden ist. Somit kann ein Laststrom von dem Hochvoltleiter 2 über die Abstandshalterhülse 11, den Hochvolt-Anschlussabschnitt 6, insbesondere dessen plattenförmigen Teilabschnitt 9, zum Hochvoltanschluss 20 des Leistungsschaltelements 8 fließen.

Weiter dargestellt ist, dass der Hochvolt-Anschlussabschnitt 6 des Kommutierungszweigs 2 über eine Schraube 12 mechanisch mit dem Hochvoltanschluss des Kommutierungskondensators 5 verbunden ist. Die Verbindungshülse 11 dient hierbei auch als Abstandshalter zur Gewährleistung des gewünschten Abstands zwischen dem Hochvolt-Anschlussabschnitt 6 und dem Hochvoltleiter 2.

Weiter dargestellt ist, dass der Niedervoltanschluss des Kommutierungskondensators 5 über eine Schraube 13 mit dem Niedervoltleiter 3 verbunden ist. Weiter ist zwischen dem Niedervoltanschluss des Kommutierungskondensators 5 und dem plattenförmig ausgebildeten Abschnitt des Niedervoltleiters 3 eine weitere Abstandshalterhülse 14 angeordnet ist, die einen gewünschten Abstand zwischen dem Kommutierungskondensator 5 und dem Niedervoltleiter 3 gewährleistet und ebenfalls eine elektrische Verbindung zwischen diesen herstellt.

Diese Abstandshülse 14 erstreckt sich hierbei durch eine Durchgangsöffnung in dem plattenförmigen Teilabschnitt 9 des Hochvolt-Anschlussabschnitts 6. Somit erstreckt sich also auch eine Schraube 13, die den Niedervoltleiter 3 mit dem Niedervoltanschluss des Kommutierungskondensators 5 mechanisch verbindet, und die in der Abstandshalterhülse 14 angeordnet ist, durch diese Durchgangsöffnung.

Ebenfalls dargestellt ist, dass der Niedervoltleiter 3 über eine Schraube 16 mit dem Niedervoltanschluss des Leistungsschaltelements 8 verbunden ist, wobei zwischen diesen Komponenten 3, 8 ebenfalls eine Abstandshülse 17 angeordnet ist, die einen gewünschten Abstand zwischen dem Leistungsschaltelement 8 und dem Niedervoltleiter 3 und deren elektrische Verbindung gewährleistet.

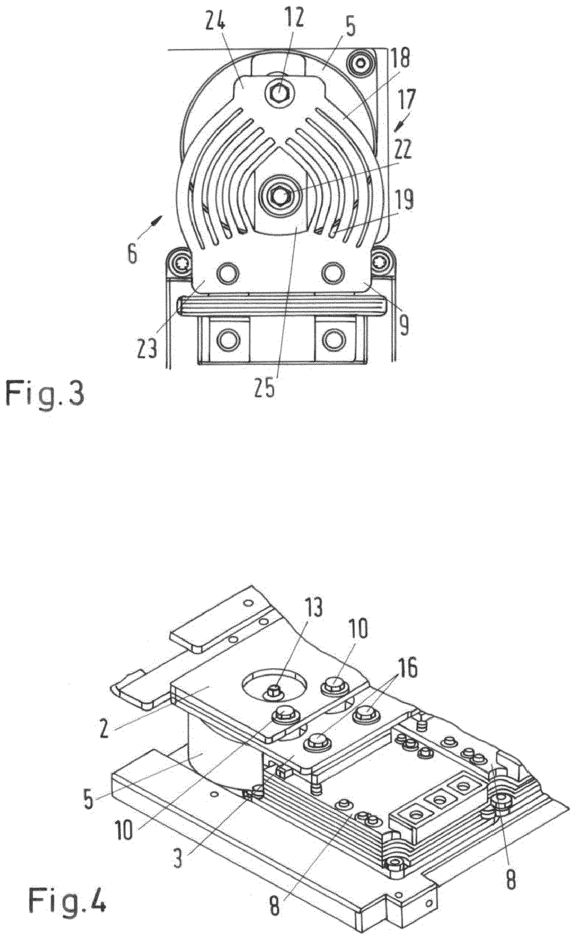

Fig. 3 zeigt eine schematische Draufsicht auf einen Hochvolt-Anschlussabschnitt 6 des Kommutierungszweigs 4 (siehe Fig. 1) gemäß einer ersten Ausführungsform. Dargestellt ist ebenfalls der Kommutierungskondensator 5 sowie die Schraube 12 zur Verbindung des Hochvoltanschlusses des Kommutierungskondensators 5 mit dem Hochvolt-Anschlussabschnitt 6 als auch die Schraube 22 zur Verbindung des Niedervoltanschlusses des Kommutierungskondensators 5 mit dem Niedervoltleiter 3.

Dargestellt ist, dass der plattenförmige Teilabschnitt 9 des Hochvolt-Anschlussabschnitts 6 einen ersten vollflächigen bzw. als Vollkörper ausgebildeten Randbereich 23 aufweist, der elektrisch und mechanisch mit dem Hochvoltleiter 2 und dem Hochvoltanschluss des Leistungsschaltelements 8 verbunden ist. Weiter dargestellt ist ein zweiter vollflächig bzw. als Vollkörper ausgebildeter Randbereich 24 des Hochvolt-Anschlussabschnitts 6, der elektrisch und mechanisch mit dem Hochvoltanschluss des Kommutierungskondensators 5 verbunden ist. Weiter umfasst der Hochvolt-Anschlussabschnitt 6, insbesondere dessen plattenförmig ausgebildeter Teilabschnitt 9, einen geschlitzten Bereich 17, wobei dieser Stege 18 und zwischen den Stegen angeordnete Schlitze 19 aufweist. Durch die Stege 18 werden der vorhergehend erläuterte erste Randbereich 23 und der zweite Randbereich 24 verbunden. Es ist alternativ aber auch möglich, dass der gesamte Hochvolt-Anschlussabschnitt 6 vollflächig bzw. als Vollkörper ausgebildet ist.

In dem in Fig. 3 dargestellten Ausführungsbeispiel ist zwischen den Stegen 18 Luft angeordnet. Allerdings ist es auch möglich, dort von Luft verschiedenes, elektrisch nicht leitfähiges Material anzuordnen. In einem zentralen Bereich des geschlitzten Bereichs 17 bildet dieser eine Durchgangsöffnung 25 aus, durch die sich die Verbindungsschraube 22 sowie die Abstandshalterhülse 14 erstrecken kann.

Weiter variiert eine Breite der Stege 18 im geschlitzten Bereich 17. Dargestellt ist, dass eine Breite der Stege 18 von einem Randbereich hin zum zentralen Bereich abnimmt. Hierdurch lassen sich die Widerstände der verschiedene Stege 18 jeweils auf einen gewünschten Wert, insbesondere den gleichen Wert, einstellen, um eine gewünschte Stromverteilung auf die Stege 18 zu erreichen. Ebenfalls variiert eine Breite der Schlitze 19 im geschlitzten Bereich 17, wobei eine Breite der Zwischenräume/Schlitze zwischen benachbarten Stegen 18 hin zum zentralen Bereich zunimmt. Diese Variation der Breite der Schlitze 19 ist jedoch optional.

Fig. 4 zeigt eine perspektivische Ansicht einer erfindungsgemäßen Schaltungsanordnung 1. Diese kann mehrere parallel geschaltete Leistungsschaltelemente 8, die jeweils mit einem Hochvoltleiter 2 und einem Niedervoltleiter 3 verbunden sind, umfassen, wobei der Übersichtlichkeit halber nur ein Leistungsschaltelement 8 vollständig dargestellt ist. Ebenfalls ersichtlich ist ein Kommuntierungskondensator 5. Weiter dargestellt sind die Verbindungsschrauben 10, 16, 13 zur Verbindung von Anschlüssen und dem Hochvolt- bzw. Niedervoltleiter 2, 3. Nicht dargestellt ist, dass der Hochvoltleiter 2 und/oder der Niedervoltleiter 3 geschlitzt ausgebildet sein kann/können, wobei sich Schlitze von einem Längsrand des jeweiligen Leiters 2 hin, aber nicht vollständig bis, zum gegenüberliegenden Längsrand erstrecken. Derartige Schlitze können beispielsweise in Teilbereichen des Hochvoltleiters 2 angeordnet sein, der zwei benachbarte Leistungsschaltelement 8 überdeckt.

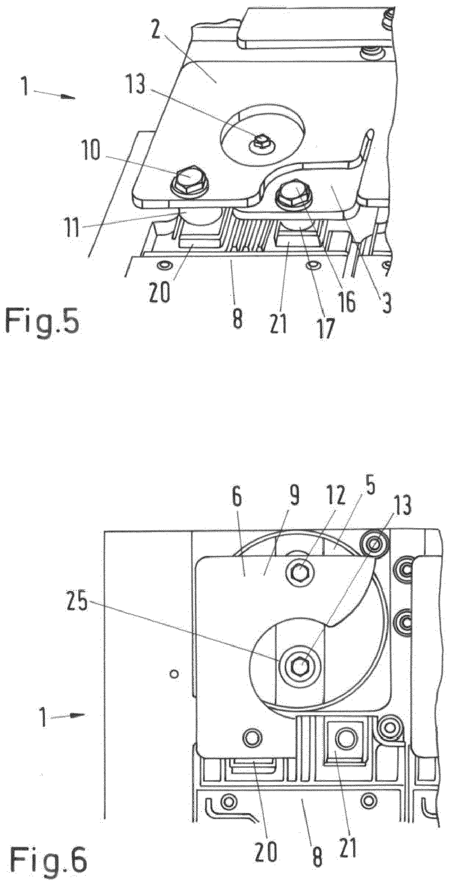

In der in Fig. 4 dargestellten Ausführungsform weisen die Leistungsschaltelemente 8 jeweils zwei Hochvoltanschlüsse 20 (nicht in Fig. 5 ersichtlich) und jeweils zwei Niedervoltanschlüsse 21 (ebenfalls nicht in Fig. 5 ersichtlich) auf. Die beiden Hochvoltanschlüsse 20 eines Leistungsschaltelements 8 sind jeweils über eine Schraube 10 und eine nicht ersichtliche Abstandshalterhülse 11 mit dem Hochvoltleiter 2 elektrisch und mechanisch verbunden. Die beiden Niedervoltanschlüsse 21 eines Leistungsschaltelements 8 sind jeweils über eine Schraube 16 und eine nicht ersichtliche Abstandshalterhülse 17 mit dem Niedervoltleiter 3 elektrisch und mechanisch verbunden.

Fig. 5 zeigt eine perspektivische Ansicht gemäß der Schaltungsanordnung 1 in einer weiteren Ausführungsform. Auch diese kann mehrere parallel geschaltete Leistungsschaltelemente 8, die jeweils mit einem Hochvoltleiter 2 und einem Niedervoltleiter 3 verbunden sind, umfassen, wobei der Übersichtlichkeit halber nur ein Leistungsschaltelement 8 vollständig dargestellt ist.

Im Unterschied zu der in Fig. 4 dargestellten Ausführungsform weist jedes Leistungsschaltelement 8 jeweils nur einen Hochvoltanschluss 20 und einen Niedervoltanschluss 21 auf. Der Hochvoltanschluss 20 eines Leistungsschaltelements 8 ist über eine Schraube 10 und eine Abstandshalterhülse 11 mit dem Hochvoltleiter 2 elektrisch und mechanisch verbunden. Ein Niedervoltanschluss 21 des Leistungsschaltelements 8 ist dann über eine Schraube 16 und eine Abstandshalterhülse 17 mit dem Niedervoltleiter 3 elektrisch und mechanisch verbunden.

Weiter in Fig. 5 dargestellt ist eine Schraube 13, die zur Verbindung eines Niedervoltanschlusses des in Fig. 6 nicht ersichtlichen Kommutierungskondensators 5 mit dem Niedervoltleiter 3 dient.

In einem Bereich über dieser Schraube 13 weist der Hochvoltleiter 2 eine Durchgangsöffnung auf, um eine Zugänglichkeit zur Schraube 13 zu gewährleisten. Die Richtungsangabe "über" bezieht sich hierbei auf eine Vertikalrichtung, die von dem Niedervolteiter 3 hin zum Hochvoltleiter 2 orientiert ist, wobei der Hochvoltleiter 2 in Vertikalrichtung über dem Niedervoltleiter 3 angeordnet ist.

Weiter dargestellt ist, dass der Hochvoltleiter 2 in einem Bereich über dem Niedervoltanschluss 21 des Leistungsschaltelements 8 bzw. über der Schraube 16 eine Aussparung aufweist, wobei die Schraube 16 teilweise in dieser Aussparung angeordnet ist. Hierdurch wird eine Zugänglichkeit zur Schraube 16 gewährleistet. Gleichzeitig wird gewährleistet, dass ein gewünschter Abstand zwischen Teilen mit Niedervoltpotential, nämlich der Schraube 16, und Teilen mit Hochvoltpotential, nämlich dem Hochvoltleiter 2, gewährleistet ist.

Weiter weist der Niedervoltleiter 3 in einem Bereich über dem Hochvoltanschluss 20 eine Aussparung auf, wobei sich die Schraube 10 und die Abstandshalterhülse 11 durch diese Aussparung hindurch erstreckt. Hierdurch wird gewährleistet, dass ein gewünschter Abstand zwischen Teilen mit Niedervoltpotential (hier der Niedervoltleiter 3) und Teilen mit Hochvoltpotential (hier die Abstandshalterhülse 11) gewährleistet ist.

Fig. 6 zeigt eine Draufsicht auf Hochvolt-Anschlussabschnitte 6 der in Fig. 5 dargestellten Ausführungsform der erfindungsgemäßen Schaltungsanordnung 1.

Erkennbar sind die plattenförmigen Teilabschnitte 9 der Hochvolt-Anschlussabschnitte 6. Weiter dargestellt sind die Kommutierungskondensatoren 5 sowie die Schraube 12 zur Verbindung des Hochvolt-Anschlussabschnitts 6 mit einem Hochvoltanschluss des Kommutierungskondensators 6 sowie die Schraube 13 zur Verbindung des Niedervoltanschlusses des Kommutierungskondensators 5 mit dem in Fig. 5 dargestellten Niedervoltleiter 3.

Ebenfalls dargestellt sind der Hochvoltanschluss 20 und der Niedervoltanschluss 21 eines Leistungsschaltelements 8. Wiederum sind der Übersichtlichkeit halber nur für eines der sechs parallel geschalteten Leistungsschaltelemente 8 Bezugszeichen dargestellt.

Im Unterschied zu der in Fig. 3 dargestellten Ausführungsform ist der plattenförmige Teilabschnitt 9 des Hochvolt-Anschlussabschnitts 6 nicht geschlitzt ausgebildet. In der in Fig. 6 dargestellten Ausführungsform weist der plattenförmige Teilabschnitt 9 ein im Wesentlichen L-förmiges Profil auf, wobei die in Fig. 5 dargestellte Abstandshalterhülse 12 einen ersten Schenkel des L-förmigen Profils in Bereich eines freien Endabschnitts dieses ersten Schenkels kontaktiert, insbesondere in einem Bereich über dem Hochvolt-Anschlussabschnitt 20 des Leistungsschaltelements 8. Ein weiterer Schenkel des L-förmigen Profilelements ist über die Schraube 12 mit dem Hochvoltanschluss des Kommutierungskondensators 5 mechanisch und elektrisch verbunden.

Weiter bildet der plattenförmige Teilabschnitt 9 eine teilkreisförmige Durchgangsöffnung 25 aus, durch die die Schraube 13 und eine nicht dargestellte Abstandshalterhülse sich vom Niedervoltanschluss des Kommutierungskondensators 5 zum Niedervoltleiter 3 erstreckt. Aufgrund der teilkreisförmigen Durchgangsöffnung 25 variiert eine Breite der Schenkel des L-förmigen plattenförmigen Teilabschnitts 9.

Die in Fig. 5 und Fig. 6 dargestellte Ausführungsform dient insbesondere zur elektrischen Verbindung eines Zwischenkreiskondensators mit Leistungsschaltelementen, wobei eine Zwischenkreisspannung bis zu 3.600 V betragen kann. Die in Fig. 4 dargestellte Ausführungsform dient vorzugsweise für Ausführungsformen mit Zwischenkreisspannungen bis zu 1.800 V.

Für die dargestellten Ausführungsformen ist nur beschrieben, dass der Hochvolt-Anschlussabschnitt 6 des Kommutierungszweigs 4 zumindest teilweise durch ein Material ausgebildet, dessen elektrische Leitfähigkeit geringer als die elektrische Leitfähigkeit des Materials des Hochvoltleiters 2 ist. Es ist jedoch alternativ oder kumulativ auch möglich, dass der Niedervolt-Anschlussabschnitt 7 des Kommutierungszweigs 4 zumindest teilweise durch ein Material ausgebildet, dessen elektrische Leitfähigkeit geringer als die elektrische Leitfähigkeit des Materials des Niedervoltleiters 3 ist.

### Bezugszeichenliste

- 1: Schaltungsanordnung
- 2: Hochvoltleiter
- 3: Niedervoltleiter
- 4: Kommutierungszweig
- 5: (Kommutierungs-)Kondensator
- 6: Hochvolt-Anschlussabschnitt
- 7: Niedervolt-Anschlussabschnitt
- 8: Leistungsschaltelement
- 9: plattenförmiger Teilabschnitt
- 10: Schraube
- 11: Abstandshalterhülse
- 12: Schraube
- 13: Schraube
- 14: Abstandshalterhülse
- 16: Schraube
- 17: geschlitzter Teilbereich
- 18: Steg
- 19: Zwischenraum
- 20: Hochvoltanschluss
- 21: Niedervoltanschluss
- 23: erster Randbereich
- 24: zweiter Randbereich
- 25: Durchgangsöffnung

## Patentansprüche

1. Elektrische Schaltungsanordnung, umfassend mindestens ein Leistungsschaltelement (8), einen Hochvoltleiter (2), einen Niedervoltleiter (3) und mindestens einen Kommutierungszweig (4), wobei der Kommutierungszweig (4) einen elektrisch mit dem Hochvoltleiter (2) verbundenen Hochvolt-Anschlussabschnitt (6), einen elektrisch mit dem Niedervoltleiter (3) verbundenen Niedervolt-Anschlussabschnitt (7) und mindestens ein als Snubber-Kondensator ausgebildetes kapazitives Element (5) umfasst, welches elektrisch zwischen dem Hochvolt-Anschlussabschnitt (6) und dem Niedervolt-Anschlussabschnitt (7) angeordnet ist, wobei der Hochvolt-Anschlussabschnitt (6) des Kommutierungszweigs (4) zumindest teilweise durch ein Material ausgebildet ist, dessen elektrische Leitfähigkeit geringer ist als die elektrische Leitfähigkeit des Materials des Hochvoltleiters (2) und/oder der Niedervolt-Anschlussabschnitt (7) des Kommutierungszweigs (4) zumindest teilweise durch ein Material ausgebildet ist, dessen elektrische Leitfähigkeit geringer ist als die elektrische Leitfähigkeit des Materials des Niedervoltleiters (2),
**dadurch gekennzeichnet, dass**
der Hochvoltleiter (2) und der Niedervoltleiter (3) jeweils mindestens einen plattenförmig ausgebildeten Abschnitt umfassen, wobei die plattenförmig ausgebildeten Abschnitte parallel zueinander angeordnet sind, wobei der Hochvolt-Anschlussabschnitt (6) und/oder der Niedervolt-Anschlussabschnitt (7) des Kommutierungszweigs (4) zumindest einen plattenförmig ausgebildeten Teilabschnitt (9) umfasst, der parallel zu den plattenförmigen Abschnitten des Hoch- und Niedervoltleiters (2, 3) und auf einer dem Hochvoltleiter (2) abgewandten Seite des Niedervoltleiters (3) angeordnet ist.

2. Elektrische Schaltungsanordnung nach Anspruch 1, **dadurch gekennzeichnet, dass** der Hochvolt-Anschlussabschnitt (6) und/oder der Niedervolt-Anschlussabschnitt (7) zumindest teilweise plattenförmig ausgebildet ist.

3. Elektrische Schaltungsanordnung nach einem der vorangegangenen Ansprüche, **dadurch gekennzeichnet, dass** zumindest ein Teilabschnitt (17) des Hochvolt-Anschlussabschnitts (6) und/oder des Niedervolt-Anschlussabschnitts (7) geschlitzt ausgebildet ist.

4. Elektrische Schaltungsanordnung nach Anspruch 3, **dadurch gekennzeichnet, dass** zumindest ein Randbereich (23, 24) des Hochvolt-Anschlussabschnitts (6) und/oder des Niedervolt-Anschlussabschnitts (7) vollflächig ausgebildet ist.

5. Elektrische Schaltungsanordnung nach einem der vorangegangenen Ansprüche, **dadurch gekennzeichnet, dass** der Hochvolt-Anschlussabschnitt (6) und/oder der Niedervolt-Anschlussabschnitt (7) des Kommutierungszweigs (4) zumindest teilweise durch Edelstahl ausgebildet ist.

6. Elektrische Schaltungsanordnung nach einem der vorangegangenen Ansprüche, **dadurch gekennzeichnet, dass** eine Dicke des plattenförmig ausgebildeten Teilabschnitts (9) geringer als eine Dicke des plattenförmigen Abschnitts des Hochvoltleiters (2) und/oder geringer als eine Dicke des plattenförmigen Abschnitts des Niedervoltleiters (3) ist.

7. Elektrische Schaltungsanordnung nach einem der vorangegangenen Ansprüche, **dadurch gekennzeichnet, dass** ein Abstand zwischen dem plattenförmig ausgebildeten Teilabschnitt (9) und dem plattenförmigen Abschnitt des Niedervoltleiters (3) gleich dem Abstand zwischen dem plattenförmig ausgebildeten Teilabschnitt (9) und dem plattenförmigen Abschnitt des Hochvoltleiters (2) ist.

8. Elektrische Schaltungsanordnung nach einem der vorangegangenen Ansprüche, **dadurch gekennzeichnet, dass** ein Hochvolt-Anschluss (20) des Leistungsschaltelements (8) über den Hochvolt-Anschlussabschnitt (6) mit dem Hochvoltleiter (2) und/oder das ein Niedervolt-Anschluss des Leistungsschaltelements (8) über den Niedervolt-Anschlussabschnitt (7) mit dem Niedervoltleiter (3) verbunden ist.

9. Elektrische Schaltungsanordnung nach einem der vorangegangenen Ansprüche, **dadurch gekennzeichnet, dass** der Hochvolt-Anschlussabschnitt (6) eine Durchgangsöffnung (25) aufweist oder ausbildet, die zur Anordnung des Niedervolt-Anschlussabschnitts (7) ausgebildet ist, und/oder dass der Niedervolt-Anschlussabschnitt (7) eine Durchgangsöffnung aufweist oder ausbildet, die zur Anordnung des Hochvolt-Anschlussabschnitts (6) ausgebildet ist.

10. Schienenfahrzeug mit einer elektrischen Schaltungsanordnung nach einem der Ansprüche 1 bis 9.

11. Verfahren zur Herstellung einer elektrischen Schaltungsanordnung (1), wobei mindestens ein Leistungsschaltelement (8), mindestens ein Hochvoltleiter (2), mindestens ein Niedervoltleiter (3) und mindestens ein Kommutierungszweig (4) mit einem Hochvolt-Anschlussabschnitt (6), einem Niedervolt-Anschlussabschnitt (7) und mindestens einem als Snubber-Kondensator ausgebildeten kapazitiven Element (5), welches elektrisch zwischen dem Hochvolt-Anschlussabschnitt (6) und dem Niedervolt-Anschlussabschnitt (7) angeordnet ist, bereitgestellt wird, wobei weiter der Hochvolt-Anschlussabschnitt (6) elektrisch mit dem Hochvoltleiter (2) und der Niedervolt-Anschlussabschnitt (7) elektrisch mit dem Niedervoltleiter (3) verbunden wird, wobei der Hochvolt-Anschlussabschnitt (6) des Kommutierungszweigs (4) zumindest teilweise durch ein Material ausgebildet wird, dessen elektrische Leitfähigkeit geringer als die elektrische Leitfähigkeit des Materials des Hochvoltleiters (2) ist, und/oder der Niedervolt-Anschlussabschnitt (7) des Kommutierungszweigs (4) zumindest teilweise durch ein Material ausgebildet wird, dessen elektrische Leitfähigkeit geringer als die elektrische Leitfähigkeit des Materials des Niedervoltleiters (2) ist, wobei der Hochvoltleiter (2) und der Niedervoltleiter (3) jeweils mindestens einen plattenförmig ausgebildeten Abschnitt umfassen, wobei die plattenförmig ausgebildeten Abschnitte parallel zueinander angeordnet sind, wobei der Hochvolt-Anschlussabschnitt (6) und/oder der Niedervolt-Anschlussabschnitt (7) des Kommutierungszweigs (4) zumindest einen plattenförmig ausgebildeten Teilabschnitt (9) umfasst, der parallel zu den plattenförmigen Abschnitten des Hoch- und Niedervoltleiters (2, 3) und auf einer dem Hochvoltleiter (2) abgewandten Seite des Niedervoltleiters (3) angeordnet ist.
